# EUROPÄISCHE PATENTSCHRIFT

(11) **EP 0 839 093 B1**
(45) Veröffentlichungstag und Bekanntmachung des Hinweises auf die Patenterteilung: **10.02.1999**
(21) Anmeldenummer: 96923913.6
(22) Anmeldetag: 25.06.1996
(51) Int. Cl.: B41J 29/15

(54) **STEUERGERÄT**
CONTROL DEVICE
UNITE DE COMMANDE

(30) Priorität: 15.07.1995 DE 29511459 U
(43) Veröffentlichungstag der Anmeldung: 06.05.1998
(73) Patentinhaber: Rittal-Werk Rudolf Loh GmbH & Co. KG, 35745 Herborn (DE)
(72) Erfinder: NEUHOF, Markus, D-35630 Ehringshausen (DE); ROOT, Paul, D-35080 Bad Endbach (DE)
(74) Vertreter: Fleck, Hermann-Josef, Dr.-Ing.
(86) Internationale Anmeldenummer: EP9602758
(87) Internationale Veröffentlichungsnummer: WO9703838

(56) Entgegenhaltungen:
- EP-A- 0 569 316
- WO-A-88/06856
- GB-A- 2 222 515
- DE - C - 4 413 543

## Beschreibung

Die Erfindung betrifft ein Steuergerät wie z.B aus DE-C-4 413 543 bekannt, dessen Gehäuse die unterschiedlichsten elektrischen Baugruppen aufnehmen kann. Dabei wird die offene Frontseite in der Regel mit einer Bedienungs- und Anzeigeelemente tragenden Frontplatte abgedeckt. Derartige Steuergeräte werden auf Standsäulen oder am Ende eines Tragarmsystems angebracht und sind in der Regel in ihrer Stellung veränderbar. Dazu sind die Gehäuse bekannter Steuergeräte mit Griffstücken versehen, die die Handhabung derselben erleichtern.

Es ist Aufgabe der Erfindung, ein Steuergerät zu schaffen, bei dem in einfacher Weise Elemente zur einfachen Handhabung eingebracht sind, die zudem eine weitere Funktion übernehmen kann.

Diese Aufgabe wird nach der Erfindung dadurch gelöst, daß das Gehäuse an seiner offenen Frontseite mit einem aus Rahmenschenkeln und Eckverbindern zusammengesetzten geschlossenen Frontrahmen versehen ist, daß über jeweils zwei Abstandsstücke an beiden vertikalen Seiten des Frontrahmens Griffstangen angebracht sind und daß an einer Griffstange mittels Verbindungsschellen ein mit einer Klemmleiste versehener Konzepthalter angebracht ist.

Die Griffstangen stehen im Abstand zu den vertikalen Seiten des Gehäuses, so daß sie gut gefaßt werden können. Der Konzepthalter kann wahlweise je nach Benutzungsart auf der linken oder rechten Seite des Steuergerätes angebracht werden. Mit der Klemmleiste kann ein Schaltplan, eine Bedienungsanleitung oder ein Schreibblatt für Notizen festgeklemmt werden. In jedem Fall wird dem Benutzer eine Hilfestellung bei der Wartung, Reparatur oder Bedienung des Steuergerätes gegeben.

Ist vorgesehen, daß die Abstandsstücke sacklochartige Aufnahmen aufweisen, in die die als Rohrabschnitt ausgebildete Griffstange eingesteckt ist, dann werden die Griffstangen ohne zusätzliche Befestigungsmittel mit den Abstandsstücken verbunden, wobei vorzugsweise ein Paß- und/oder Preßsitz zwischen den Aufnahmen in den Abstandsstücken und den Griffstangen gewählt wird.

Die Handhabung des Steuergerätes beim Verändern der Stellung desselben wird dadurch noch erleichtert, daß die Abstandsstücke so abgewinkelt sind, daß die Griffstangen vor der Frontseite des Gehäuses angeordnet sind.

Die Anbringung des Konzepthalters an der Griffstange ist nach einer ausgestaltung so gelöst, daß der Konzepthalter plattenförmig ausgebildet und an der der Griffstange zugekehrten Seite mit einem abgewinkelten Rand versehen ist, und daß dieser Rand mit den Verbindungsschellen verschraubt ist.

Die die Griffstange umschließenden Verbindungsschellen sind so ausgeführt, daß die Verbindungsschellen U-förmig ausgebildet sind und eine runde Aufnahme für die Griffstange aufweisen und daß die Schenke der Verbindungsschellen im Anschluß an die Aufnahme als Befestigungsflansche mit Befestigungsbohrungen ausgebildet sind. Der Rand des Konzepthalters kann direkt an diese Befestigungsflansche der Verbindungsschellen angeschraubt werden.

Damit der Konzepthalter in seiner Stellung optimal angepaßt werden kann, sieht eine weitere Ausgestaltung vor, daß der mit den Verbindungsschellen verbundene Konzepthalter an der Griffstange verschwenkbar und in der eingestellten Schwenkstellung festlegbar ist.

Die Ausgestaltung ist vorzugsweise so, daß der Konzepthalter rechteckförmig ausgebildet und mit seiner großen Abmessung parallel zur Griffstange ausgerichtet ist, wobei der Rand des plattenförmigen Konzepthalters über zwei, in den Eckbereichen der Griffstange angebrachten Verbindungsschellen mit der Griffstange verbunden ist.

Da die Eckverbinder sowieso mit den Rahmenschenkeln des Frontrahmens verbunden werden müssen, ist eine Ausgestaltung von Vorteil, die dadurch gekennzeichnet ist, daß die Abstandsstücke mit den zugekehrten Eckverbindern des Frontrahmens verbunden, z.B. verschraubt sind.

Die Erfindung wird anhand eines in den Zeichnungen dargestellten Ausführungsbeispiels näher erläutert. Es zeigen:

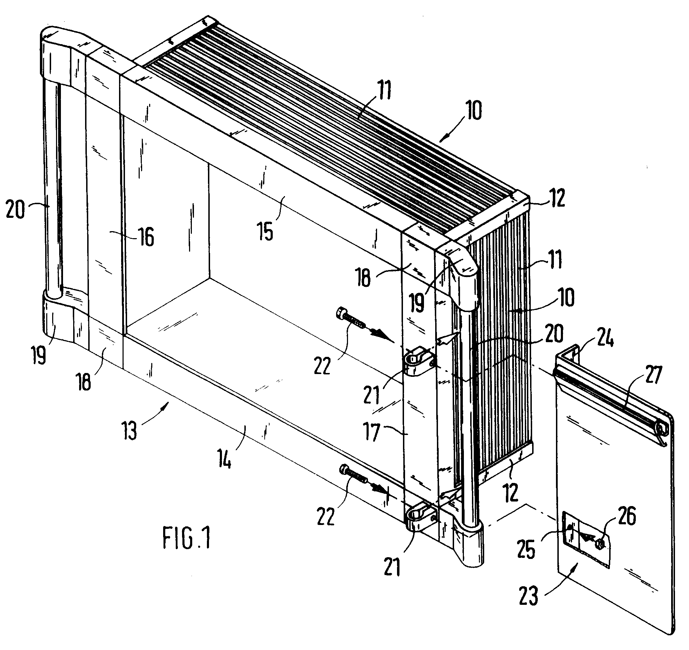

- Fig. 1: in perspektivischer Vorderansicht das Steuergerät, bei dem das nicht bestückte Gehäuse an beiden Seiten mit einer Griffstange versehen ist und bei dem sich die für die Anbringung eines Konzepthalters vorgesehenen Teile in Montagestellung befinden, und
- Fig. 2: in vergrößerter Teilansicht den an der rechten Griffstange angebrachten Konzepthalter.

Das Gehäuse 10 des Steuergerätes wird aus Wandelementen 11 und Eckstücken 12 zusammengesetzt. Die offene Frontseite des Gehäuses 10 wird mit einem geschlossenen Frontrahmen 13 abgedeckt. Der Frontrahmen umschließt eine Aufnahme, die mittels einer Frontplatte oder dgl. verschlossen werden kann. Der Frontrahmen ist aus den vier Rahmenschenkeln 14,15, 16 und 17 sowie vier Eckverbindern 18 zusammengesetzt und mit dem Gehäuse 10 fest verbunden. An den beiden vertikalen Seiten des Frontrahmens 13 werden mit den Eckverbindern 18 abgewinkelte Abstandsstücke 19 verbunden, die auf den einander zugekehrten Seiten mit sacklochartigen Aufnahmen für eine Griffstange 20 versehen sind. Die als Rohrabschnitte ausgebildeten Griffstangen 20 werden in diese Aufnahmen der Abstandsstücke 19 eingesteckt und vorzugsweise durch Paß- und/oder Preßsitz darin gehalten. Die Abstandsstücke 19 sind so abgewinkelt, daß die Griffstangen 20 im Abstand zum Gehäuse 10 und vor der Frontseite des Steuergerätes angeordnet sind.

Auf die rechte Griffstange 20 können zwei U-förmige Verbindungsschellen 21 aufgeklipst werden, die eine runde Aufnahme für die Griffstange 20 aufweisen. Im Anschluß an diese Aufnahme bilden die Schenkel der Verbindungsschellen 21 mit Befestigungsbohrungen versehene Befestigungsflansche. Der plattenförmige Konzepthalter 23 ist mit seiner großen Abmessung vertikal ausgerichtet. Er trägt an seiner Oberkante und Vorderseite eine Klemmleiste 27 für die festzulegende Vorlage, einen Schaltplan, eine Bedienungsanweisung, ein Notizblatt oder dgl. Die der Griffstange 20 zugekehrte Seite des Konzepthalters 23 ist mit einem nach hinten abgewinkelten Rand 24 versehen, der mit Befestigungsbohrungen 25 versehen ist. Der Rand 24 des Konzepthalters 23 kann mit Befestigungsschrauben 22 und Muttern 26 direkt an den Befestigungsflanschen der Verbindungsschellen 21 festgeschraubt werden. Die Befestigungsschrauben 22 können dabei auch zur Arretierung der Schwenkstellung des Konzepthalters 23 verwendet werden.

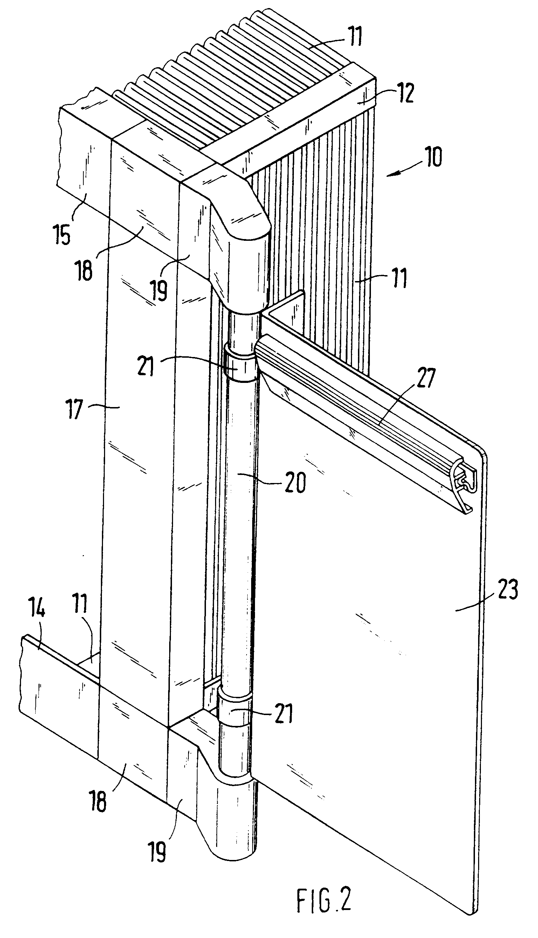

Wie die Fig. 2 zeigt, sind die beiden Verbindungsschellen 21 in die vertikalen Endbereiche der Griffstange 20 verlagert, damit eine möglichst verwindungssteife Verbindung zwischen Griffstange 20 und Konzepthalter 23 erreicht wird.

Die Abstandsstücke 19 werden mit den Eckverbindern 18 des Frontrahmens 13 fest verbunden, z.B. verschraubt. Die Eckverbinder 18 selbst sind wiederum mit den Rahmenschenkeln 14,15, 16 und 17 verbunden, so daß der Frontrahmen 13 und der Konzepthalter 23 eine stabile Einheit bilden.

## Patentansprüche

1. Steuergerät mit einem Gehäuse (10), das eine offene Frontseite aufweist, dadurch gekennzeichnet, daß das Steuergerät an seiner offenen Frontseite mit einem aus Rahmenschenkeln (14,15, 16,17) und Eckverbindern (18) zusammengesetzten, geschlossenen Frontrahmen (13) versehen ist, bei dem über jeweils zwei Abstandsstücke (19) an beiden vertikalen Seiten des Frontrahmens (13) vertikale Griffstangen (20) angebracht sind und bei dem an einer Griffstange (20) mittels Verbindungsschellen (21) ein mit einer Klemmleiste (27) versehener Konzepthalter (23) angebracht ist.

2. Steuergerät nach Anspruch 1,
dadurch gekennzeichnet,
daß die Abstandsstücke (19) sacklochartige Aufnahmen aufweisen, in die die als Rohrabschnitt ausgebildete Griffstange (20) eingesteckt ist.

3. Steuergerät nach Anspruch 1 oder 2,
dadurch gekennzeichnet,
daß die Abstandsstücke (19) so abgewinkelt sind, daß die Griffstangen (20) vor der Frontseite des Gehäuses (10) angeordnet sind.

4. Steuergerät nach einem der Ansprüche 1 bis 3,
dadurch gekennzeichnet,
daß der Konzepthalter (23) plattenförmig ausgebildet und an der der Griffstange (20) zugekehrten Seite mit einem abgewinkelten Rand (24) versehen ist, und daß dieser Rand (24) mit den Verbindungsschellen (21) verschraubt ist.

5. Steuergerät nach einem der Ansprüche 1 bis 4,
dadurch gekennzeichnet,
daß die Verbindungsschellen (21) U-förmig ausgebildet sind und eine runde Aufnahme für die Griffstange (20) aufweisen und daß die Schenkel der Verbindungsschellen (21) im Anschluß an die Aufnahme als Befestigungsflansche mit Befestigungsbohrungen ausgebildet sind.

6. Steuergerät nach einem der Ansprüche 1 bis 5,
dadurch gekennzeichnet,
daß der mit den Verbindungsschellen (21) verbundene Konzepthalter (23) an der Griffstange (20) verschwenkbar und in der eingestellten Schwenkstellung festlegbar ist.

7. Steuergerät nach einem der Ansprüche 1 bis 6,
dadurch gekennzeichnet,
daß der Konzepthalter (23) rechteckförmig ausgebildet und mit seiner großen Abmessung parallel zur Griffstange (20) ausgerichtet ist.

8. Steuergerät nach Anspruch 7,
dadurch gekennzeichnet,
daß der Rand (24) des plattenförmigen Konzepthalters (23) über zwei, in den Endbereichen der Griffstange (20) angebrachten Verbindungsschellen (21) mit der Griffstange (20) verbunden ist.

9. Steuergerät nach einem der Ansprüche 1 bis 8,
dadurch gekennzeichnet,
daß die Abstandsstücke (19) mit den zugekehrten Eckverbindern (18) des Frontrahmens (13) verbunden, z.B. verschraubt sind.

## Claims

1. Control apparatus, having a housing (10) which includes an open front side, characterised in that the control apparatus is provided, on its open front side, with a closed front frame (13) assembled from frame portions (14,15, 16,17) and corner connectors (18), wherein vertical grip rods (20) are mounted on both vertical sides of the front frame (13) via two respective spacer members (19), and wherein a copyholder (23), which is provided with a clamping strip (27), is mounted on a grip rod (20) by means of connection clamps (21).

2. Control apparatus according to claim 1, characterised in that the spacer members (19) have blind hole-like receivers, into which the grip rod (20), configured as a tubular portion, is inserted.

3. Control apparatus according to claim 1 or 2, characterised in that the spacer members (19) are bent-over in such a manner that the grip rods (20) are disposed in front of the front side of the housing (10).

4. Control apparatus according to one of claims 1 to 3, characterised in that the copyholder (23) has a plate-like configuration and is provided with a bent-over edge (24) on the side facing the grip rod (20), and in that this edge (24) is screw-connected to the connection clamps (21).

5. Control apparatus according to one of claims 1 to 4, characterised in that the connection clamps (21) have a U-shaped configuration and include a round receiver for the grip rod (20), and in that the portions of the connection clamps (21) communicating with the receiver are configured as mounting flanges with mounting bores.

6. Control apparatus according to one of claims 1 to 5, characterised in that the copyholder (23), which is connected to the connection clamps (21), is pivotable on the grip rod (20) and is securable in the set pivotal position.

7. Control apparatus according to one of claims 1 to 6, characterised in that the copyholder (23) has a rectangular configuration and is aligned with its large dimension parallel to the grip rod (20).

8. Control apparatus according to claim 7, characterised in that the edge (24) of the plate-like copyholder (23) is connected to the grip rod (20) via two connection clamps (21) mounted in the end regions of the grip rod (20).

9. Control apparatus according to one of claims 1 to 8, characterised in that the spacer members (19) are connected, e.g. screw-connected, to the facing corner connectors (18) of the front frame (13).

## Revendications

1. Unité de commande avec un boîtier (10) présentant une face frontale ouverte, caractérisée en ce que sa face frontale ouverte est dotée d'un cadre frontal fermé (13) composé d'ailes d'encadrement (14, 15, 16, 17) et de connecteurs d'angle (18), cadre (13) auquel par l'intermédiaire de deux paires de pièces d'écartement (19) sont , de part et d'autre du cadre frontal (13), fixées des tiges de saisie (20) et à laquelle sur une des tiges de saisie (20) est, par l'intermédiaire de étriers de connexion (23), fixé un porte-document doté d'une latte de serrage (23).

2. Unité de commande suivant la revendication 1, caractérisée
en ce que les pièces d'écartement (19) présentent des logements en cul de sac, dans lesquels est enfichée la tige de saisie (20) en forme de tronçon tubulaire.

3. Unité de commande suivant la revendication 1 ou 2, caractérisée
en ce que les pièces d'écartement (19) sont coudés de manière telle que les tiges de saisie (20) sont disposées devant la face frontale du boîtier (10).

4. Unité de commande suivant l'une quelconque des revendications de 1 à 3,
caractérisée
en ce que le porte-document (23) est en forme de plaque et présente un bord coudé (24) du côté orienté vers la tige de saisie (20), et en ce que ce bord (24) est fixé par vis aux étriers de connexion (21).

5. Unité de commande suivant l'une quelconque des revendications de 1 à 4,
caractérisée
en ce que les étriers de connexion (21) sont en forme de U et présentent un logement circulaire pour la tige de saisie (20, et
en ce que les branches des étriers de connexion (21) présentent, derrière le logement, la forme de brides de fixation présentant des forures de fixation.

6. Unité de commande suivant l'une quelconque des revendications de 1 à 5,
caractérisée
en ce que le porte-document (23) relié aux étriers de connexion (21) est monté à pivotement sur la tige de saisie (20) et peut être bloqué dans la position de pivotement choisie.

7. Unité de commande suivant l'une quelconque des revendications de 1 à 6,
caractérisée
en ce que le porte-document (23) est de forme rectangulaire et que sa plus grande dimension est parallèle à la tige de saisie (20).

8. Unité de commande suivant la revendication 6
caractérisée
en ce que le bord (24) du porte-document (23) en forme de plaque est, par l'intermédiaire de deux étriers de connexion (21) disposés dans les zones terminales de la tige de saisie (20), relié à la tige de saisie (20).

9. Unité de commande suivant l'une quelconque des revendications de 1 à 8,
caractérisée
en ce que les pièces d'écartement (19) sont reliés aux connecteurs d'angle (18) respectifs du cadre frontal (13), par exemple au moyen de vis.
